# EUROPEAN PATENT SPECIFICATION

(11) **EP 3 923 300 B1**
(45) Date of publication and mention of the grant of the patent: **11.10.2023**
(21) Application number: 19927346.7
(22) Date of filing: 13.05.2019
(51) Int. Cl.: H01B 1/22, H01B 13/00, H01L 31/0224, C08L 63/00, C08K 3/08

(54) **LOW-TEMPERATURE CONDUCTIVE SILVER PASTE FOR HIT SOLAR CELL AND PREPARATION METHOD THEREFOR**
NIEDRIGTEMPERATUR-LEITFÄHIGE SILBERPASTE FÜR HIT-SOLARZELLE UND VERFAHREN ZUR HERSTELLUNG DAVON
PÂTE D'ARGENT CONDUCTRICE À BASSE TEMPÉRATURE POUR CELLULE SOLAIRE HIT ET PROCÉDÉ DE PRÉPARATION ASSOCIÉ

(30) Priority: 29.04.2019 CN 201910354164
(43) Date of publication of application: 15.12.2021
(73) Proprietor: Nantong T-Sun New Energy Co., Ltd., Nantong, Jiangsu 226010 (CN)
(72) Inventor: ZHU, Peng, Nantong, Jiangsu 226000 (CN); WANG, Yuanyuan, Nantong, Jiangsu 226000 (CN); CHEN, Fen, Nantong, Jiangsu 226000 (CN)
(74) Representative: Sun, Yiming
(86) International application number: PCT/CN2019/086565
(87) International publication number: WO 2020/220395

(56) References cited:
- EP-A1- 2 455 947
- WO-A1-2014/013872
- CN-A- 104 685 002
- CN-A- 106 085 276
- CN-A- 108 264 879
- CN-A- 108 264 879
- CN-A- 108 565 041
- CN-A- 108 598 190
- JP-B2- S6 343 041

## Description

### TECHNICAL FIELD

The present invention relates to the field of macromolecule-based conductive materials and, in particular, to a low temperature-conductive silver paste for an HIT solar cell and a method for preparing the same.

### BACKGROUND

HIT is the abbreviation for Heterojunction with Intrinsic Thin-layer, and is also called HJT or SHJ (Silicon Heterojunction solar cell) as it has been applied by Sanyo corporation (Japan) as a registered trademark. A solar cell of such kind was first successfully developed by Sanyo corporation (Japan) in 1990, having a conversion efficiency of up to 14.5% (a 4-mm² cell). With continuous improvement by Sanyo corporation, the conversion efficiency of the Sanyo HIT cell reached 25.6% in 2015.

The heterojunction solar cell has a transparent conducting optical film (TCO) on the surface. As the TCO film has a higher volume resistivity, on the surface of the TCO film will be printed grid lines formed of a conductive adhesive paste to better collect generated electrons. The heterojunction solar cell cannot endure high temperature due to an amorphous silicon passivation layer comprised therein. Therefore, a low temperature-curing paste capable of being cured at low temperature, instead of the solar paste for a conventional solar cell, must be used. The low temperature-curing paste used at present is mainly an epoxy silver-containing low temperature-paste. In order to reduce the volume resistivity of the paste, the amount of a silver powder added is typically required to reach 90%, leading to a higher cost of the low temperature-paste, which is unfavorable for large-scale popularization of the heterojunction solar cells.

Chinese Patent No. CN108598190A provides a low temperature-silver paste for a low-density HIT solar cell and a method for preparing the same. In that invention, the low temperature-silver paste comprises 30-90% of a silver powder having a low apparent density, 5-60% of a resin monomer, 0.1-10% of a solvent and 0.1-5% of an initiator for curing the resin monomer; as the silver powder of low apparent density used generally has larger specific surface area, the solid content of the paste is low, leading to large volume resistance and poor cell performance; as the epoxy resin used has poor tenacity, the shrinkage of the resin will compromise the close contact of paste with a substrate during curing; as the bisphenol F epoxy resin selected has a rigid structure, and has poor tenacity and heat resistance, the rigid structure of the epoxy resin may be damaged during welding; the silver powder has a larger particle size, which is unfavorable for finger printing.

Chinese Patent No. CN109300574A discloses a transparent low temperature-silver paste for an HIT solar cell and a method for preparing the same. In that patent, a nano-silver wire, a resin monomer, a solvent and a curing initiator are selected to prepare a transparent low temperature-silver paste for highly conductive HIT solar cell. In that invention, the nano-silver wire used is too long for printing; as the resin selected has poor tenacity, the shrinkage of the resin will compromise the close contact of paste with a substrate during curing.

### SUMMARY

Purpose: In order to remedy the defects in the prior art, the present invention provides a low temperature-conductive silver paste for an HIT solar cell and a method for preparing the same. In the present invention, the low temperature-conductive silver paste for an HIT solar cell is prepared based on the combination of a flake silver powder, a spherical silver powder, a resin, a diluent, an organic solvent, a curing agent, a curing accelerator, a dispersant, a thixotropic agent and the like, and is characterized by good adhesion, a good printing property, a high fill factor, good wettability and a low curing temperature.

Technical Scheme: The present invention is intended to provide a low temperature-conductive silver paste for an HIT solar cell and a method for preparing the same as defined in the appended claims.

Beneficial Effects: The present invention has the following advantages:
(1) According to a low temperature-conductive silver paste for an HIT solar cell of the present invention, a resin of high molecular weight such as phenolic epoxy resin and polyurethane modified epoxy resin is adopted, so that the conductive silver paste has good flexibility, and isocyanate modified epoxy resin can improve the aging resistance of the paste; in addition, in the formula, trimethylolpropane triglycidyl ether, an epoxy reactive diluent of lower molecular weight, is selected to improve the wettability of the paste on a substrate. The use of phenolic epoxy resin in conjunction with trimethylolpropane triglycidyl ether is favorable for improving the welding stress of the cured paste, and also ensures the wettability of the paste on the substrate, which facilitates the contact between the silver powder and the substrate.
(2) According to a low temperature-conductive silver paste for an HIT solar cell of the present invention, a small molecular reactive diluent and ionomer are selected, such that the prepared paste can form bonding with a substrate, thereby improving the fill factor and the photoelectric conversion efficiency.

### BRIEF DESCRIPTION OF THE DRAWINGS

FIG. 1 shows SEM electron micrographs of a low temperature-conductive silver paste for an HIT solar cell of the present invention printed on an HIT solar cell; and
FIG. 2 shows SEM electron micrographs of a low temperature-conductive silver paste for an HIT solar cell of the comparative example printed on an HIT solar cell.

### DETAILED DESCRIPTION

The technical schemes in the embodiments of the present invention will be clearly and completely described below, for a better understanding of the advantages and features of the present invention by those skilled in the art, and for a more the clearly defined protection scope of the present invention.

### Example 1

Provided is a low temperature-conductive silver paste for an HIT solar cell, which is prepared from the following components in percentages by mass:

| | |
|---|---|
| a flake silver powder | 27.6%; |
| a spherical silver powder | 62.9%; |
| phenolic epoxy resin | 2%; |
| trimethylolpropane triglycidyl ether | 1%; |
| diethylene glycol butyl ether acetate | 4%; |
| methylhexahydrophthalic anhydride | 0.7%; |
| 2-ethyl-4-methylimidazole | 0.1%; |
| a dispersant | 0.4%; |
| a modified hydrogenated castor oil | 0.3%; and |
| an ionomer | 1%. |

2% of phenolic epoxy resin was immersed in 1% of diethylene glycol butyl ether acetate according to the above formula, heated to 65 °C, and incubated for 2 h to give a first organic mixture;
0.4% of the dispersant was immersed in 1% of diethylene glycol butyl ether acetate according to the ratios, heated to 25 °C, and incubated and stirred for 1.5 h to give a second organic mixture;
The first organic mixture obtained in S1, the second organic mixture obtained in S2, 0.3% of the modified hydrogenated castor oil, 2% of diethylene glycol butyl ether acetate, 0.7% of methylhexahydrophthalic anhydride, 1% of trimethylolpropane triglycidyl ether, 1% of the ionomer and 0.1% of 2-ethyl-4-methylimidazole were sequentially mixed at room temperature to give a third organic composition;
27.6% of the flake silver powder having a particle size of 4 µm, a tap density of 5.5 g/cm³ and a loss on ignition of 0.05%, and 62.9% of the spherical silver powder having a particle size of 0.65 µm and a tap density of 4.5 g/cm³ were finally added into the third organic composition prepared in S3, well mixed and ground to give the low temperature-conductive silver paste of the present invention; the viscosity of the low temperature-conductive silver paste for an HIT solar cell was detected to be 30 Pa S at a rotation speed of 10 rpm.

### Example 2

Provided is a low temperature-conductive silver paste for an HIT solar cell, which is prepared from the following components in percentages by mass:

| | |
|---|---|
| a flake silver powder | 27.6%; |
| a spherical silver powder | 60%; |
| isocyanate modified epoxy resin | 3%; |
| trimethylolpropane triglycidyl ether | 1%; |
| diethylene glycol dibutyl ether | 1.5%; |
| diethylene glycol butyl ether acetate | 1.83%; |
| trimethylhexamethylenediamine | 0.7%; |
| 2-undecylimidazole | 0.1%; |
| a dispersant | 0.4%; |
| polyamide wax | 0.507%; |
| an epoxy toughening agent | 1.363%; and |
| an ionomer | 1%. |

3% of the organic silicone modified epoxy resin was immersed in 0.83% of diethylene glycol butyl ether acetate according to the above formula, heated to 50 °C, and incubated for 3 h to give a first organic mixture;
0.4% of the dispersant was immersed in 1% of diethylene glycol butyl ether acetate according to the ratios, heated to 5 °C, and incubated and stirred for 2 h to give a second organic mixture;
The first organic mixture obtained in S1, the second organic mixture obtained in S2, 0.507% of polyamide wax, 1.5% of diethylene glycol dibutyl ether, 0.7% of trimethylhexamethylenediamine, 1% of the ionomer, 1% of trimethylolpropane triglycidyl ether, 1.363% of the epoxy toughening agent and 0.1% of 2-undecylimidazole were sequentially mixed at room temperature to give a third organic composition;
27.6% of the flake silver powder having a particle size of 6 µm, a tap density of 6g/cm³ and a loss on ignition of 0.02%, and 60% of the spherical silver powder having a particle size of 0.5 µm and a tap density of 5g/cm³ were finally added into the third organic composition prepared in S3, well mixed and ground to give the low temperature-conductive silver paste of the present invention; the viscosity of the low temperature-conductive silver paste for an HIT solar cell was detected to be 45 Pa S at a rotation speed of 10 rpm.

### Example 3

Provided is a low temperature-conductive silver paste for an HIT solar cell, which is prepared from the following components in percentages by mass:

| | |
|---|---|
| a flake silver powder | 46%; |
| a spherical silver powder | 44%; |
| polyurethane modified epoxy resin | 2%; |
| trimethylolpropane triglycidyl ether | 1%; |
| diethylene glycol dibutyl ether | 1%; |
| diethylene glycol butyl ether acetate | 1.33%; |
| aminoethylpiperazine | 0.7%; |
| 2-undecylimidazole | 0.1%; |
| a dispersant | 0.4%; |
| polyamide wax | 0.107%; |
| an epoxy toughening agent | 2.363%; and |
| an ionomer | 1%. |

2% of polyurethane modified epoxy resin was immersed in 0.33% of diethylene glycol butyl ether acetate according to the above formula, heated to 80 °C, and incubated for 1 h to give a first organic mixture;
0.4% of the dispersant was immersed in 1% of diethylene glycol butyl ether acetate according to the ratios, heated to 45 °C, and incubated and stirred for 1 h to give a second organic mixture;
The first organic mixture obtained in S1, the second organic mixture obtained in S2, 0.107% of polyamide wax, 1% of diethylene glycol dibutyl ether, 0.7% of aminoethylpiperazine, 1% of the ionomer, 2.363% of the epoxy toughening agent, 1% of trimethylolpropane triglycidyl ether and 0.1% of 2-undecylimidazole were sequentially mixed at room temperature to give a third organic composition;
46% of the flake silver powder having a particle size of 2 µm, a tap density of 8g/cm³ and a loss on ignition of 0.01%, and 44% of the spherical silver powder having a particle size of 0.8 µm and a tap density of 6g/cm³ were finally added into the third organic composition prepared in S3, well mixed and ground to give the low temperature-conductive silver paste of the present invention; the viscosity of the low temperature-conductive silver paste for an HIT solar cell was detected to be 60 Pa·S at a rotation speed of 10 rpm.

### Comparative Example

In this Comparative Example, the transparent low temperature-silver paste for an HIT solar cell was prepared using the following method: 40 g of ethyl acetate and 500 g of a nano-silver wire were weighed and well mixed to form a transparent solution, wherein the nano-silver wire had an average diameter of 8 nm and a length of 50 µm; 170 g of butyl methacrylate was added under stirring; after 30 min of stirring at room temperature to ensure that the nano-silver wire was uniformly dispersed in butyl methacrylate, 1.9 g of benzoyl peroxide was added and stirred for 1 h; the mixture was defoamed at low pressure to give the low temperature-silver paste for an HIT solar cell.

The same amount of the low temperature-conductive silver pastes in Examples 1 to 3 and Comparative Example was printed on a silicon wafer of a solar cell, dried and sintered to give an HIT solar cell. The results are shown in Table 1:

**Table 1**

| Item | Open-circuit voltage (V) | Short-circuit current (A) | Series resistance (Ω) | Parallel resistanc e (Ω) | Fill factor (%) | Conversio n efficiency (%) |
|---|---|---|---|---|---|---|
| Example 1 | 0.811 | 9.614 | 0.0013 | 2459 | 80.1 | 24.63 |
| Example 2 | 0.795 | 9.651 | 0.0015 | 2389 | 80.6 | 24.89 |
| Example 3 | 0.801 | 9.621 | 0.0016 | 2478 | 81.1 | 24.64 |
| Comparativ e Example | 0.731 | 9.512 | 0.0022 | 2540 | 79.5 | 23.03 |

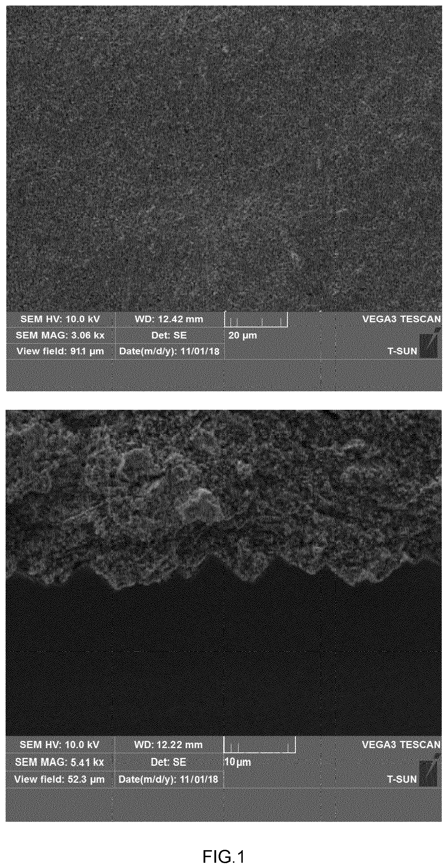

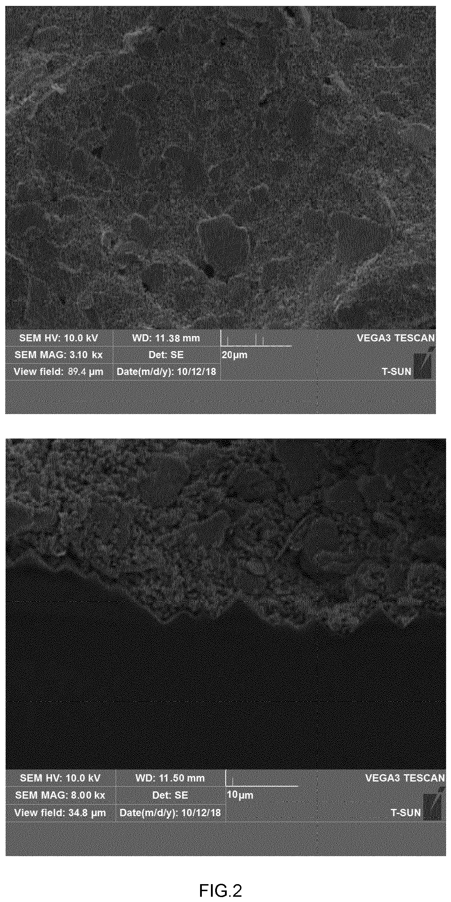

As can be seen from Table 1, the conversion efficiency of the silver paste prepared according to the present invention is 24.63-24.89%, and the silver-aluminum paste prepared using the method of the present invention can be cured at about 200 °C. Therefore, an HIT solar cell of high efficiency can be prepared. As can be seen from the comparison of the silver paste of the present invention as shown in FIG. 1 and the silver paste prepared in Comparative Example as shown in FIG. 2, the silver paste of the present invention has a higher surface density, and contacts more closely with a substrate.

## Claims

1. A low temperature-conductive silver paste for an HIT solar cell, comprising the following components in part by mass:
a flake silver powder 27-46 parts;
a spherical silver powder 46-65 parts;
a thermosetting resin 1.5-3.5 parts;
a reactive diluent 0.5-1.5 parts;
an organic solvent 2-4 parts;
a curing agent 0.65-0.75 parts;
an imidazole curing accelerator0.05-0.15 parts;
a dispersant 0.35-0.45 parts;
a thixotropic agent 0.01-0.6 parts;
an epoxy toughening agent 0-2.4 parts; and
an ionomer 0.5-1.5 parts,
in a total of 100 parts.

2. The low temperature-conductive silver paste for an HIT solar cell according to claim 1, wherein the thermosetting resin is one of a phenolic epoxy resin, an isocyanate modified epoxy resin and a polyurethane modified epoxy resin.

3. The low temperature-conductive silver paste for an HIT solar cell according to claim 1, wherein the reactive diluent is trimethylolpropane triglycidyl ether.

4. The low temperature-conductive silver paste for an HIT solar cell according to claim 1, wherein the curing agent is selected from methylhexahydrophthalic anhydride, trimethylhexamethylenediamine and aminoethylpiperazine.

5. The low temperature-conductive silver paste for an HIT solar cell according to claim 1, wherein the imidazole curing accelerator is selected from 2-ethyl-4-methylimidazole and 2-undecylimidazole.

6. The low temperature-conductive silver paste for an HIT solar cell according to claim 1, wherein the organic solvent is one selected from diethylene glycol butyl ether acetate and diethylene glycol dibutyl ether, or a mixture thereof.

7. A method for preparing the low temperature-conductive silver paste for an HIT solar cell according to claim 1, comprising:
S1, immersing the thermosetting resin in the organic solvent according to the ratios, heating to 50-80 °C, and incubating for 0.5-3 h to give a first organic mixture;
S2, immersing the thixotropic agent in the organic solvent according to the ratios, heating to 5-45 °C, incubating and stirring for 1-2 h to give a second organic mixture;
S3, sequentially mixing the first organic mixture obtained in S1, the second organic mixture obtained in S2, the dispersant, the organic solvent, the curing agent, the epoxy toughening agent, the reactive diluent, the ionomer and the imidazole curing accelerator according to their ratios at room temperature to give a third organic composition; and
S4, adding the flake silver powder and the spherical silver powder into the third organic composition prepared in S3, mixing well and grinding to give the low temperature-conductive silver paste.

## Patentansprüche

1. Bei niedriger Temperatur leitende Silberpaste für eine HIT-Solarzelle, umfassend die folgenden Bestandteile in Massenteilen:
ein flockiges Silberpulver 27-46 Teile;
ein kugelförmiges Silberpulver 46-65 Teile;
ein duroplastisches Harz 1,5-3,5 Teile;
ein reaktives Verdünnungsmittel 0,5-1,5 Teile;
ein organisches Lösungsmittel 2-4 Teile;
einen Härtungsmittel 0,65-0,75 Teile;
einen Imidazol-Härtungsbeschleuniger 0,05-0,15 Teile;
ein Dispergiermittel 0,35-0,45 Teile;
ein Thixotropiermittel 0,01-0,6 Teile;
ein Epoxidharz-Zähigkeitsmittel 0-2,4 Teile; und
ein lonomer 0,5-1,5 Teile,
in insgesamt 100 Teilen.

2. Bei niedriger Temperatur leitende Silberpaste für eine HIT-Solarzelle nach Anspruch 1, wobei das duroplastische Harz eines von einem Phenol-Epoxidharz, einem isocyanatmodifizierten Epoxidharz oder einem polyurethanmodifizierten Epoxidharz ist.

3. Bei niedriger Temperatur leitende Silberpaste für eine HIT-Solarzelle nach Anspruch 1, wobei das reaktive Verdünnungsmittel Trimethylolpropantriglycidylether ist.

4. Bei niedriger Temperatur leitende Silberpaste für eine HIT-Solarzelle nach Anspruch 1, wobei das Härtungsmittel ausgewählt ist aus Methylhexahydrophthalsäureanhydrid, Trimethylhexamethylendiamin und Aminoethylpiperazin.

5. Bei niedriger Temperatur leitfähige Silberpaste für eine HIT-Solarzelle nach Anspruch 1, wobei der Imidazol-Härtungsbeschleuniger aus 2-Ethyl-4-methylimidazol und 2-Undecylimidazol ausgewählt ist.

6. Bei niedriger Temperatur leitende Silberpaste für eine HIT-Solarzelle nach Anspruch 1, wobei das organische Lösungsmittel eines ist, ausgewählt aus Diethylenglykolbutyletheracetat und Diethylenglykoldibutylether oder einer Mischung davon.

7. Verfahren zur Herstellung der bei niedriger Temperatur leitfähigen Silberpaste für eine HIT-Solarzelle nach Anspruch 1, umfassend:
S1, Eintauchen des duroplastischen Harzes in das organische Lösungsmittel entsprechend den Verhältnissen, Erwärmen auf 50 bis 80 °C und Inkubieren für 0,5 bis 3 Stunden, um eine erste organische Mischung zu ergeben;
S2, Eintauchen des Thixotropiermittels in das organische Lösungsmittel entsprechend den Verhältnissen, Erwärmen auf 5 bis 45 °C, Inkubieren und Rühren für 1 bis 2 Stunden, um eine zweite organische Mischung zu ergeben;
S3, nacheinander Mischen der ersten organischen Mischung, die in S1 erhalten wird, der zweiten organischen Mischung, die in S2 erhalten wird, des Dispergiermittels, des organischen Lösungsmittels, des Härtungsmittels, des Epoxid-Zähigkeitsmittels, des reaktiven Verdünnungsmittels, des Ionomers und des Imidazol-Härtungsbeschleunigers entsprechend ihren Verhältnissen bei Raumtemperatur, um eine dritte organische Zusammensetzung zu ergeben; und
S4, Hinzufügen des flockigen Silberpulvers und des kugelförmigen Silberpulvers zu der in S3 hergestellten dritten organischen Zusammensetzung, gründliches Mischen und Mahlen, um die bei niedriger Temperatur leitfähige Silberpaste zu ergeben.

## Revendications

1. Pâte d'argent conductrice à basse température pour une cellule solaire HIT, comprenant les composants suivants en partie en masse :
une poudre d'argent en flocons 27 à 46 parties ;
une poudre d'argent sphérique 46 à 65 parties ;
une résine thermodurcissable 1,5 à 3,5 parties ;
un diluant réactif 0,5 à 1,5 partie ;
un solvant organique 2 à 4 parties ;
un agent de durcissement 0,65 à 0,75 partie ;
un accélérateur de durcissement
imidazolique 0,05 à 0,15 partie ;
un dispersant 0,35 à 0,45 partie ;
un agent thixotrope 0,01 à 0,6 partie ;
un agent de renforcement époxy 0 à 2,4 parties ; et
un ionomère 0,5 à 1,5 partie,
pour un total de 100 parties.

2. Pâte d'argent conductrice à basse température pour une cellule solaire HIT selon la revendication 1, dans laquelle la résine thermodurcissable est l'une parmi une résine époxy phénolique, une résine époxy modifiée par un isocyanate et une résine époxy modifiée par un polyuréthane.

3. Pâte d'argent conductrice à basse température pour cellule solaire HIT selon la revendication 1, dans laquelle le diluant réactif est l'éther triglycidylique de triméthylolpropane.

4. Pâte d'argent conductrice à basse température pour cellule solaire HIT selon la revendication 1, dans laquelle l'agent de durcissement est sélectionné parmi l'anhydride méthylhexahydrophtalique, la triméthylhexaméthylènediamine et l'aminoéthylpipérazine.

5. Pâte d'argent conductrice à basse température pour une cellule solaire HIT selon la revendication 1, dans laquelle l'accélérateur de durcissement imidazolique est sélectionné parmi le 2-éthyl-4-méthylimidazole et le 2-undécylimidazole.

6. Pâte d'argent conductrice à basse température pour une cellule solaire HIT selon la revendication 1, dans laquelle le solvant organique est un solvant sélectionné parmi l'acétate d'éther butylique de diéthylène glycol et l'éther dibutylique de diéthylène glycol, ou un mélange de ceux-ci.

7. Procédé de préparation de la pâte d'argent conductrice à basse température pour une cellule solaire HIT selon la revendication 1, comprenant :
S1, immersion de la résine thermodurcissable dans le solvant organique selon les rapports, chauffage entre 50 et 80 °C et incubation pendant 0,5 à 3 h pour obtenir un premier mélange organique ;
S2, immersion de l'agent thixotrope dans le solvant organique selon les rapports, chauffage entre 5 et 45 °C, incubation et agitation pendant 1 à 2 h pour obtenir un deuxième mélange organique ;
S3, mélange de manière séquentielle du premier mélange organique obtenu en S1, du second mélange organique obtenu en S2, du dispersant, du solvant organique, de l'agent de durcissement, de l'agent de renforcement époxy, du diluant réactif, de l'ionomère et de l'accélérateur de durcissement imidazolique en fonction de leurs rapports à température ambiante pour donner une troisième composition organique ; et
S4, ajout de la poudre d'argent en flocons et de la poudre d'argent sphérique dans la troisième composition organique préparée en S3, bien mélanger et broyer pour obtenir la pâte d'argent conductrice à basse température.
